# EUROPEAN PATENT SPECIFICATION

(11) **EP 3 462 592 B1**
(45) Date of publication and mention of the grant of the patent: **19.10.2022**
(21) Application number: 18182978.9
(22) Date of filing: 11.07.2018
(51) Int. Cl.: H02M 7/00, H05K 7/20

(54) **INVERTER MODULE, INVERTER AND INVERTER COOLING SYSTEM**
WECHSELRICHTERMODUL, WECHSELRICHTER UND WECHSELRICHTERKÜHLSYSTEM
MODULE ONDULEUR, ONDULEUR ET SYSTÈME DE REFROIDISSEMENT D'ONDULEUR

(30) Priority: 30.09.2017 CN 201710923146
(43) Date of publication of application: 03.04.2019
(73) Proprietor: Siemens Aktiengesellschaft, 80333 München (DE)
(72) Inventor: YAO, Ji Long, Beijing, 100024 (CN); ZHAO, Yan Feng, Beijing, 100012 (CN); SHI, Lei, Beijing, 101300 (CN); LIU, Ze Wei, Beijing, 100070 (CN); ZHANG, Sheng, Langfang, Hebei (CN)
(74) Representative: Isarpatent

(56) References cited:
- CN-A- 106 208 728
- JP-A- 2000 232 288
- JP-A- 2003 259 657
- JP-A- 2009 029 187
- JP-A- 2009 239 995
- JP-A- 2013 236 476
- US-A1- 2004 223 301
- US-A1- 2012 014 062
- US-B1- 6 665 183

## Description

### Technical field

The present invention relates to an inverter cooling system.

### Background art

An inverter is an electrical device which causes changes in the voltage, frequency, number of phases, and other electrical quantities or characteristics of a power supply system. It is also referred to as a drive, and is generally used for controlling electric machines. An inverter generally comprises a rectifier for conversion of AC to DC (AC/DC), a direct current link (DC link) for decoupling and filtering, and an inversion unit for conversion of DC to AC (DC/AC). An electric power conversion function of the inverter is realized by means of a specific circuit topology formed of power semiconductor devices. During operation, the power semiconductor devices will generate significant heat, so good heat dissipation is needed to ensure operational performance.

At present, specific cooling technology is generally used to achieve dissipation of heat from the power semiconductor devices in the inverter. Methods of heat dissipation may include natural cooling of a heat sink, liquid cooling or forced air cooling with a combination of a metal heat sink and a fan, etc. In the case of general industrial inverters which are price-sensitive, air cooling is the most widely accepted method.

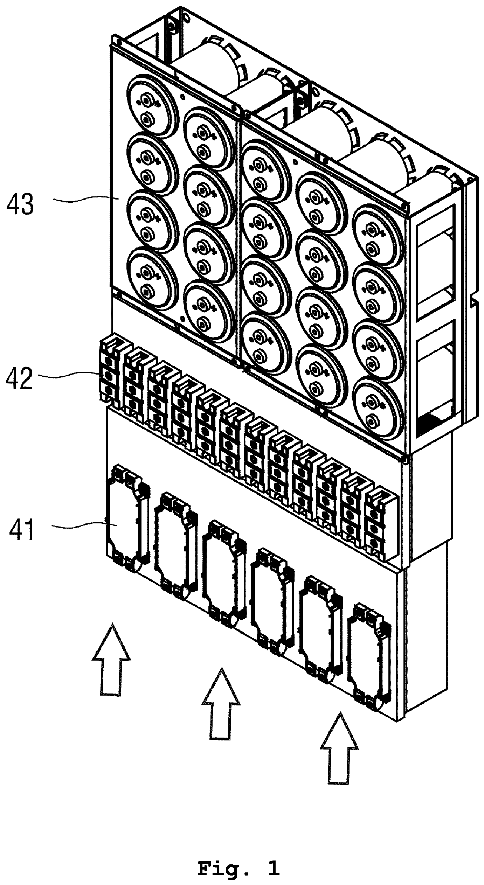

In the prior art, the power semiconductor devices forming the inverter are generally disposed in a flat, non-modular manner, and have a series cooling arrangement, with all components being distributed on the same mounting surface. Fig. 1 is a schematic diagram of series cooling of an inverter with a flat non-modular arrangement in the prior art. In fig. 1, the inverter comprises, in order from bottom to top, an inversion unit 41, a rectifier unit 42 and a DC link unit 43. Furthermore, the inversion unit 41, rectifier unit 42 and DC link unit 43 are sequentially connected in series relative to cooling air. Cooling air flows sequentially through the inversion unit 41, rectifier unit 42 and DC link unit 43 in the direction of the arrows in the figure. In the series cooling arrangement, a fan may be located at the bottom as a blower, or may suck in air at the top.

However, in series cooling, the cooling air does not flow through the inversion unit 41 and the rectifier unit 42 simultaneously, hence the inversion unit 41 and the rectifier unit 42 have different cooling effects. Furthermore, since the inverter has a flat design, the volume is large, and both installation and disassembly are inconvenient.

JP 2003 259657 A relates to a power conversion device using semiconductor elements such as an inverter device for driving a motor or the like, an uninterruptible power supply, and the like, and in particular, power conversion capable of effectively cooling the semiconductor elements.

CN 106 208 728 A relates to an air-cooled power model.

US 6 665 183 B1 relates to a power supply apparatus which may be used with an arc welder, a plasma arc welder, an arc cutter, a plasma arc cutter, a charger, and a plating apparatus.

JP 2013 236476 A describes a power conversion device with cooling fins 50U-50W that correspond to the L phases and are spaced out in a first direction (x axis). L power module groups PM-PM correspond to the L phases. The power module group PM of each phase includes M power modules PM arrayed on the cooling fin 50 of the corresponding phase in a second direction (y axis) perpendicular to the first direction. Blower means supplies air to the L cooling fins 50U-50W in the second direction. First screen means 74 is disposed upstream of the cooling fins 50U-50W to screen air flowing between adjacent cooling fins 50.

JP 2000 232288 A provides a power conversion device composed of a main circuit block equipped with a semiconductor device, cooling fins, smoothing capacitor and the like which are mounted on a mounting plate and connected with a conductor, a printed board block composed of printed boards and their cases, a cooling fan block composed of cooling fans and their mounting pads, a terminal pad block, and a box block.

JP 2009 239995 A discloses a power conversion device.

JP 2009 029187 A discloses a cooling device for electric power converters of hybrid vehicles.

US 2004/223301 A1 discloses a modular converter.

US 2012/014062 A1 discloses a cooling duct attachment and sealing for a motor drive.

### Content of the invention

The technical solution of the embodiments of the present invention is as follows:
An inverter cooling system comprising the features of patent claim 1. Preferred embodiments are recited by the dependent claims.

Clearly, an embodiment of the present invention proposes an inverter cooling system which comprises a modular and compact inverter module, wherein the rectifier unit and the inversion unit are located upstream in the flow direction of the cooling gas flow, and the DC link unit is disposed downstream in the flow direction of the cooling gas flow. The rectifier unit and the inversion unit are both located upstream in the flow direction, and can therefore both achieve a good cooling effect.

According to the invention, the rectifier unit comprises at least two rectifier elements; the inversion unit comprises at least two inversion elements; and the DC link unit comprises at least two DC link elements.

Clearly, the rectifier unit, inversion unit and DC link unit may all comprise multiple constituent elements.

According to the invention, the at least two rectifier elements are arranged along a first line, the first line being perpendicular to the flow direction of the cooling gas flow; the at least two inversion elements are arranged along a second line, the second line being perpendicular to the flow direction of the cooling gas flow.

Clearly, the rectifier elements and the inversion elements are in parallel relative to the cooling gas flow, with cooling air flowing past the rectifier elements and the inversion elements simultaneously, hence the rectifier elements and the inversion elements have the same cooling effect. Even if a semiconductor element which readily generates heat (e.g. an insulated-gate bipolar transistor or a metal oxide semiconductor field effect transistor) is used in the rectifier element, the rectifier element can still be cooled well.

In one embodiment, the first line is parallel to the second line. According to the invention the first line coincides with the second line.

Clearly, the embodiments of the present invention are very flexible with regard to the specific arrangement positions of the first line and the second line.

In one embodiment, the rectifier unit, the DC link unit and the inversion unit are all arranged on a first mounting surface of a mounting frame of the inverter module.

Clearly, the rectifier unit, the DC link unit and the inversion unit are equivalent to being arranged on the same first mounting surface, so connection of a DC bus is very convenient.

In one embodiment, a cooling fin is provided on a second side, adjoining the first mounting surface, of the mounting frame, wherein the second side is a side close to the rectifier unit and the inversion unit.

In one embodiment, an identical heat sink is allocated for the rectifier unit and the inversion unit; or
a different heat sink is allocated for the rectifier unit and the inversion unit respectively.

Clearly, the rectifier unit and the inversion unit may be allocated on the same heat sink or on different heat sinks, thus there is more than one manner of heat sink arrangement.

In one embodiment, the heat sink is located on a second mounting surface, opposite to the first mounting surface, of the mounting frame.

The rectifier unit comprises a three-phase rectifier element or a single-phase rectifier element, and the inversion unit comprises a three-phase inversion element or a single-phase inversion element.

Clearly, the rectifier unit and the inversion unit may respectively comprise a three-phase element or a single-phase element, suitable for a three-phase electricity application environment or a single-phase electricity application environment.

In one embodiment, the rectifier unit comprises a diode, a thyristor, an insulated-gate bipolar transistor or a metal oxide semiconductor field effect transistor.

Clearly, since the rectifier unit has the same cooling effect as the inversion unit, the rectifier unit may be implemented not only as a diode or a thyristor, but also as a semiconductor device having a higher requirement in terms of cooling conditions, such as an insulated-gate bipolar transistor or a metal oxide semiconductor field effect transistor.

In one embodiment, the inversion unit comprises an insulated-gate bipolar transistor or a metal oxide semiconductor field effect transistor.

In one embodiment, the DC link unit comprises a DC bus capacitor set.

Clearly, the inverter cooling system proposed in an embodiment of the present invention comprises a modular and compact inverter, wherein the rectifier unit and inversion unit have the same cooling effect, and the complexity of bus wiring will not be increased. Furthermore, due to the provision of the common wind channel, gas flows which have performed a cooling action on each inverter module can be gathered conveniently, and the gas flows gathered in the common wind channel can be drawn out by the common fan assembly, facilitating gas flow.

### Description of the accompanying drawings

The accompanying drawings below are merely intended to illustrate and explain the present invention schematically, without limiting the scope thereof, wherein:
Fig. 1 is a schematic diagram of series cooling of an inverter in the prior art.
Fig. 2 is a demonstrative modular diagram of an inverter module according to an embodiment.
Fig. 3 is a demonstrative layout diagram of an inverter module according to an embodiment.
Fig. 4 is a demonstrative three-dimensional view of an inverter module according to an embodiment.
Fig. 5 is a demonstrative front view of an inverter comprising multiple inverter modules according to an embodiment.
Fig. 6 is a top view of an inverter having a common wind channel according to an embodiment.
Fig. 7 is a demonstrative front view of an inverter cooling system having a fan assembly according to an embodiment of the present invention.
Fig. 8 is a schematic air flow diagram of an inverter cooling system according to an embodiment of the present invention.

Key to the drawings:

| Label | Meaning |
|---|---|
| 41 | inversion unit |
| 42 | rectifier unit |
| 43 | DC link unit |
| 10 | inverter module |
| 11 | rectifier unit |
| 12 | DC link unit |
| 13 | inversion unit |
| 14 | cooling fin |
| 1 | first line |
| 2 | second line |
| 3 | third line |
| 20 | inverter |
| 21 | fan assembly |
| 22 | bus |
| 23 | common wind channel |
| 24 | first mounting surface |
| 25 | second side |
| 30 | mounting frame |

### Particular embodiments

The present invention is explained in further detail below in conjunction with the accompanying drawings and embodiments, to clarify the technical solution and advantages thereof. It should be understood that the particular embodiments described here are merely intended to explain the present invention elaboratively, not to define the scope of protection thereof.

The solution of the present invention is expounded below by describing a number of representative embodiments, in order to make the description concise and intuitive. The large number of details in the embodiments are merely intended to assist with understanding of the solution of the present invention. However, obviously, the technical solution of the present invention need not be limited to these details when implemented. To avoid making the solution of the present invention confused unnecessarily, some embodiments are not described meticulously, but merely outlined. Hereinbelow, "comprises" means "including but not limited to", while "according to..." means "at least according to..., but not limited to only according to...". In line with the linguistic customs of Chinese, in cases where the quantity of a component is not specified hereinbelow, this means that there may be one or more of the component; this may also be interpreted as meaning at least one.

In an embodiment of the present invention, a modular and compact inverter module is proposed, wherein a rectifier unit and an inversion unit have the same cooling effect, and the complexity of bus wiring will not be increased. Furthermore, one or more of the inverter modules proposed in an embodiment of the present invention may form an inverter, constituting a compact inverter.

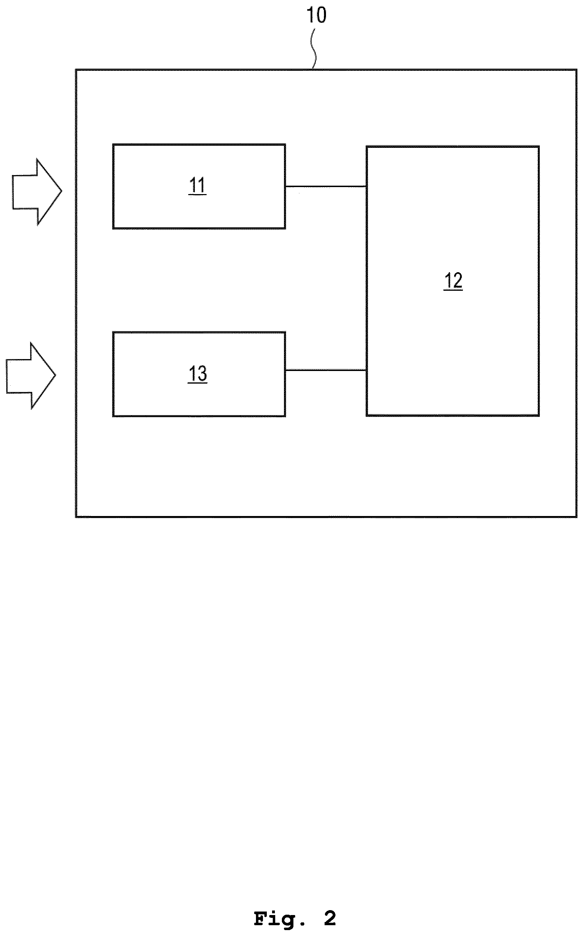

Fig. 2 is a demonstrative modular diagram of an inverter module according to an embodiment of the present invention.

As shown in fig. 2, an inverter module 10 comprises: a rectifier unit 11, a DC link unit 12 and an inversion unit 13, wherein the rectifier unit 11 and the inversion unit 13 are located upstream in a flow direction of a cooling gas flow, and the DC link unit 12 is disposed downstream in the flow direction of the cooling gas flow.

The rectifier unit 11 in the inverter module 10 is used for performing AC/DC conversion; the DC link unit 12 in the inverter module 10 is used for performing DC decoupling and filtering; the inversion unit 13 in the inverter module 10 is used for performing DC/AC conversion.

In one embodiment, the rectifier unit 11 may comprise at least two rectifier elements; the inversion unit 13 may comprise at least two inversion elements; the DC link unit 12 may comprise at least two DC link elements.

As can be seen from the demonstrative drawing in fig. 2, a top surface of the rectifier unit 11, a top surface of the DC link unit 12 and a top surface of the inversion unit 13 substantially form a first surface plane of the inverter module 10; the rectifier unit 11 and the inversion unit 13 are disposed in a direction which lies in the first surface plane and is perpendicular to the flow direction of cooling gas; the rectifier unit 11 and the DC link unit 13 are disposed upstream in the flow direction of the cooling gas flow; the DC link unit 12 is disposed downstream in the flow direction of the cooling gas flow. Clearly, the top surface of the rectifier unit 11, the top surface of the DC link unit 12 and the top surface of the inversion unit 13 are substantially located in the same plane, and together form the first surface plane of the inverter module 10. Furthermore, the rectifier unit 11 and the DC link unit 12 are arranged side by side in the flow direction of the cooling gas flow, i.e. the rectifier unit 11 and the DC link unit 13 are together disposed upstream in the cooling gas flow. Furthermore, the DC link unit 12 is disposed downstream in the cooling gas flow.

In one embodiment, the rectifier unit 11 comprises a three-phase rectifier element or a single-phase rectifier element, and the inversion unit 13 comprises a three-phase inversion element or a single-phase inversion element.

Preferably, the rectifier unit 11 may comprise a diode, a thyristor, an insulated-gate bipolar transistor (IGBT) or a metal oxide semiconductor field effect transistor (MOSFET). Preferably, the inversion unit 13 may comprise an IGBT or a MOSFET. Preferably, the DC link unit 12 may comprise a DC bus capacitor set.

A specific example of the rectifier unit 11, the DC link unit 12 and the inversion unit 13 has been described demonstratively above, but those skilled in the art will realize that such a description is merely demonstrative, and not intended to define the scope of protection of embodiments of the present invention.

In fig. 2, the rectifier unit 11 and the inversion unit 13 are disposed in parallel, side by side and spaced apart from one another, in the flow direction of cooling gas indicated by the arrows, such that the cooling gas flow simultaneously cools the rectifier unit 11 and the inversion unit 13; thus, the rectifier unit 11 and the inversion unit 13 have the same cooling effect, and even if an IGBT or MOSFET, which readily generates heat, is used in the rectifier unit 11, the rectifier unit 11 can still be cooled well. Moreover, since the rectifier unit 11, the DC link unit 12 and the inversion unit 13 are arranged on substantially the same mounting surface, connection of a DC bus is very convenient.

As shown in fig. 2, the DC link unit 12 is arranged in a downstream position in the flow direction of the cooling gas flow, i.e. the cooling gas flow first passes the rectifier unit 11 and the inversion unit 13, and then passes the DC link unit 12. Such a layout takes account of the fact that the DC link unit 12 generally has no need for heat dissipation.

Furthermore, it is possible for the rectifier unit 11 and the inversion unit 13 to be arranged on the same heat sink or on different heat sinks, with the DC link unit 12 not being arranged on a heat sink. At this time, a bottom surface of the rectifier unit 11 and a bottom surface of the inversion unit 13 are arranged on the same heat sink or on different heat sinks.

Optionally, the DC link unit 12 may also be arranged on a heat sink. For example, it is possible to arrange the rectifier unit 11 and the inversion unit 13 on one heat sink, and to arrange the DC link unit 12 on another heat sink different from the heat sink on which the rectifier unit 11 and the inversion unit 13 are located. As another example, it is possible for the rectifier unit 11 and a portion of electronic components in the DC link unit 12 to be arranged on one heat sink, and the inversion unit 13 and the remaining electronic components in the DC link unit 12 to be arranged on another heat sink different from the heat sink on which the rectifier unit 11 and the portion of electronic components in the DC link unit 12 are located.

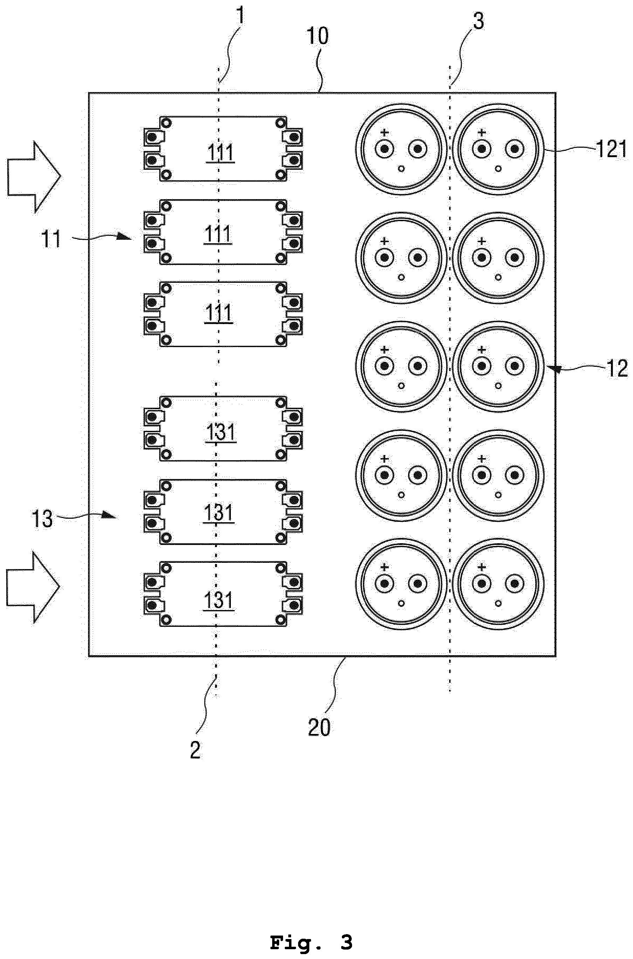

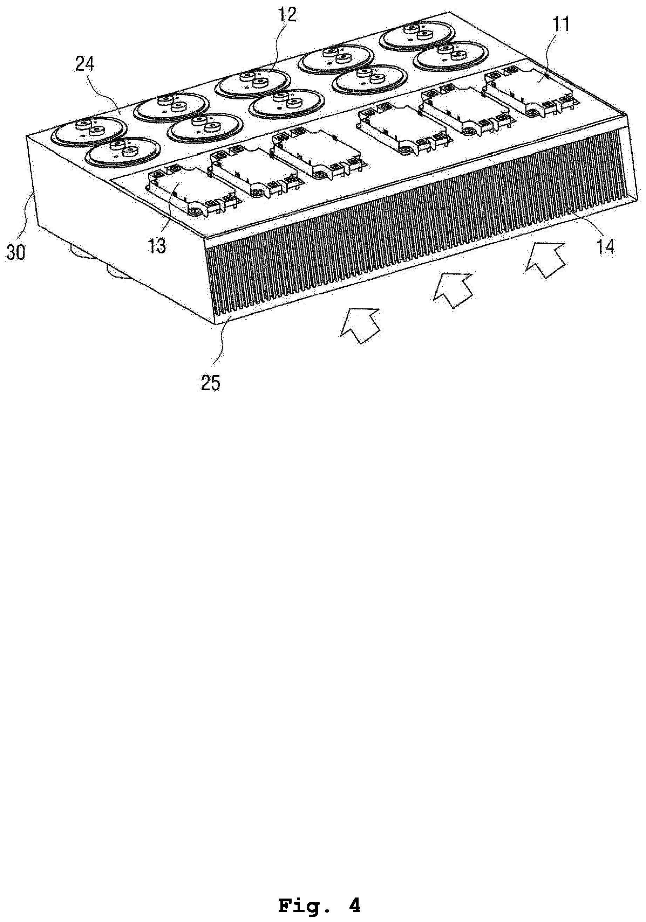

Based on the inverter module structure shown in fig. 2, fig. 3 is a demonstrative layout diagram of an inverter module according to an embodiment of the present invention, and fig. 4 is a demonstrative three-dimensional view of an inverter module according to an embodiment of the present invention.

In figs. 3 and 4, the rectifier unit 11 is implemented as three-phase rectifier elements, and the inversion unit 13 is implemented as three-phase inversion elements. The rectifier unit 11, the DC link unit 12 and the inversion unit 13 are all arranged on a first mounting surface 24 of a mounting frame 30 of the inverter module 10. Moreover, cooling fins 14 are provided on a second side 25, adjoining the first mounting surface 24, of the mounting frame 30, wherein the second side 25 is a side close to the rectifier unit 11 and the inversion unit 13.

The rectifier unit 11 is specifically implemented as three semiconductor devices (three-phase input) arranged at a top-left side of the inverter module 10, i.e. the three rectifier elements 111 shown in fig. 3. The inversion unit 13 is specifically implemented as three semiconductor devices (three-phase output) arranged at a bottom-left side of the inverter module 10, i.e. the three inversion elements 131 shown in fig. 3. The DC link unit 12 is arranged on a right side of the inverter module 10; the DC link unit 12 comprises multiple DC link elements 121 as shown in fig. 3. The DC link unit 12 is specifically implemented as a DC bus capacitor set occupying the entire right side of the inverter module 10; in this embodiment, 10 capacitors are provided, i.e. the DC link elements 121 are respectively implemented as capacitors. A bottom surface of the rectifier unit 11 and a bottom surface of the inversion unit 13 are perpendicularly arranged on one heat sink, or respectively arranged on two separate heat sinks.

As can be seen from fig. 3, the three rectifier elements 111 are respectively arranged along a first line 1, wherein the first line 1 is perpendicular to the flow direction of the cooling gas flow. The three inversion elements 131 are respectively arranged along a second line 2, wherein the second line 2 is perpendicular to the flow direction of the cooling gas flow. Preferably, the first line 1 may be parallel to the second line 2, or the first line 1 coincides with the second line 2. Preferably, the DC link elements 121 are arranged along, or in multiple rows respectively parallel to, a third line 3, wherein the third line 3 is parallel to the first line 1.

In fig. 3, a connecting terminal of the rectifier unit 11 is located on a top surface thereof, a connecting terminal of the inversion unit 13 is located on a top surface thereof, and a connecting terminal of the DC link unit 12 (generally a bus capacitor connecting terminal) is located on a top surface thereof. The top surface of the rectifier unit 11, the top surface of the DC link unit 12 and the top surface of the inversion unit 13 form a first surface plane of the inverter module 10, i.e. the top surface of the rectifier unit 11, the top surface of the DC link unit 12 and the top surface of the inversion unit 13 are located in substantially the same plane; therefore, the connection of the connecting terminal of the rectifier unit 11 to the connecting terminal of the DC link unit 12 is convenient, and the connection of the connecting terminal of the inversion unit 13 to the connecting terminal of the DC link unit 12 is convenient, so that very convenient bus connection can be achieved.

Fig. 4 shows the cooling fins 14 located on the heat sink arranged on the inverter module 10. The arrows in fig. 4 also indicate the direction of the cooling gas flow. Cooling air flow passes through the cooling fins 14, thereby taking away heat generated during operation of the inverter module 10. The rectifier unit 11 and the DC link unit 13 are disposed upstream in the cooling gas flow; the DC link unit 12 is disposed downstream in the cooling gas flow. Hence, the embodiments of the present invention can effectively and uniformly eliminate heat of the rectifier unit 11 and the inversion unit 13. Even if the rectifier unit 11 is formed of high-power semiconductor devices such as an IGBT or MOSFET, cooling will still be highly efficient. Furthermore, since the rectifier unit 11, the DC link unit 12 and the inversion unit 13 are arranged in substantially the same plane, the connection of the DC bus is very convenient, and the embodiments of the present invention can utilize cabinet height more effectively, to realize a compact system design.

Based on the description above, an embodiment of the present invention also proposes an inverter, comprising one or more inverter modules 10 as described above.

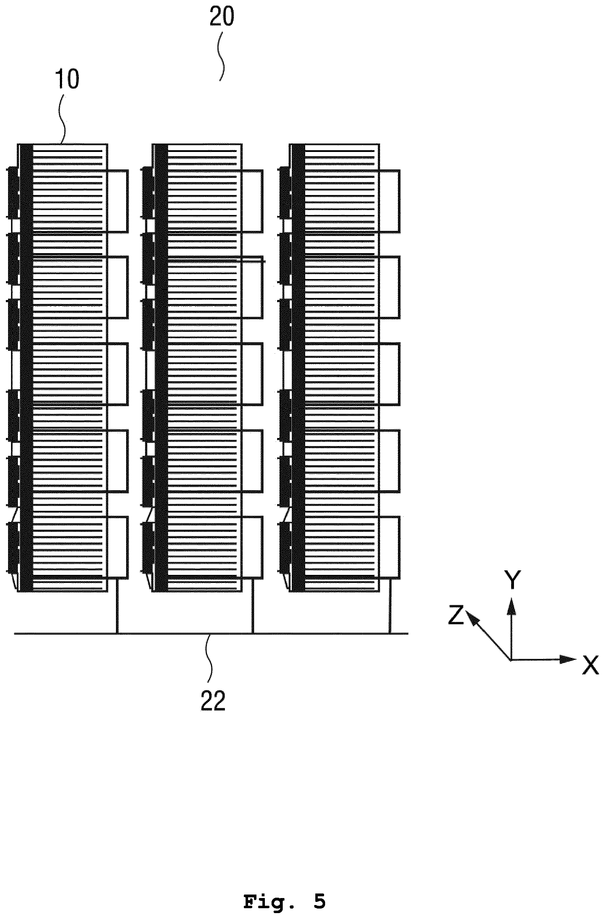

Fig. 5 is a demonstrative front view of an inverter according to an embodiment of the present invention; the direction of the view is the direction in which cooling gas flows into the inverter. In the coordinate system shown in fig. 5, the X-axis direction is a first direction, the Y-axis direction is a second direction, and the Z-axis is a third direction.

The inverter 20 comprises at least one inverter module set, each inverter module set comprising at least two inverter modules 10 arranged adjacently and in parallel in the first direction; each inverter module 10 may be implemented as the inverter module shown in figs. 2 - 4. The inverter 20 further comprises a bus 22, with each inverter module 10 being respectively connected to the bus 22 in the first direction.

In one embodiment, each inverter module set is/are arranged adjacently in the first direction.

Clearly, the inverter in embodiments of the present invention has a compact structure, and the capacity of the inverter can be easily expanded by means of identical inverter modules.

In one embodiment, the inverter 20 further comprises: a common wind channel which extends, in the second direction, past a wind outlet for cooling gas flow of each inverter module set. The common wind channel is used for gathering gas flows which have performed a cooling action on the inverter modules 10 in the inverter 20.

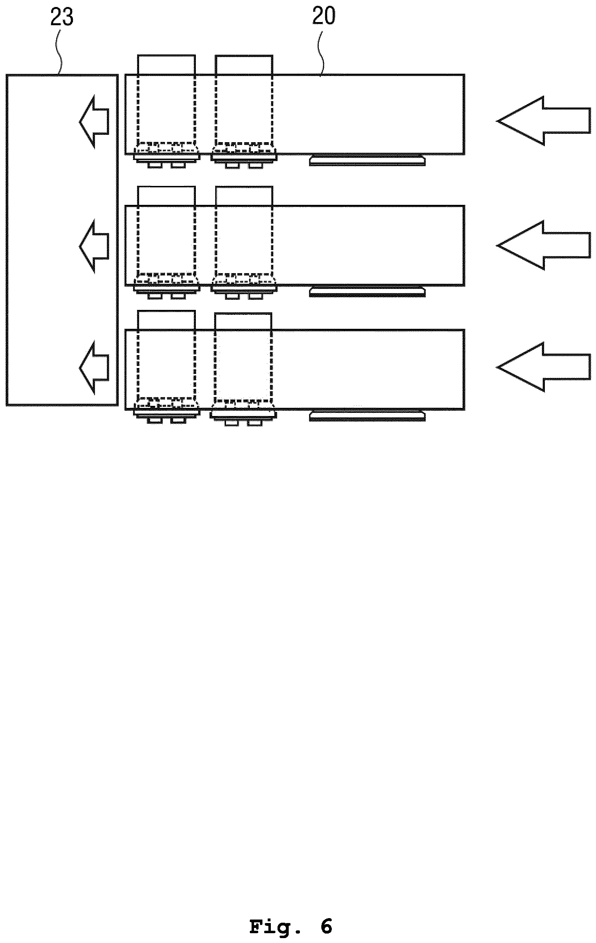

Fig. 6 is a top view of an inverter having a common wind channel according to an embodiment of the present invention. As can be seen from fig. 6, the cooling gas flow first of all flows into the rectifying unit 11 and inversion unit 13 of each inverter module 10 in the inverter 20, then the cooling gas flows past the DC link unit 12 of each inverter module 10 in the inverter 20. Finally, having fully performed the cooling action on the inverter modules 10 in the inverter 20, the gas flows are gathered together in the common wind channel 23 which extends, in the second direction, past the wind outlet for cooling gas flow of each inverter module set.

Based on the description above, an embodiment of the present invention also proposes an inverter cooling system having a fan assembly.

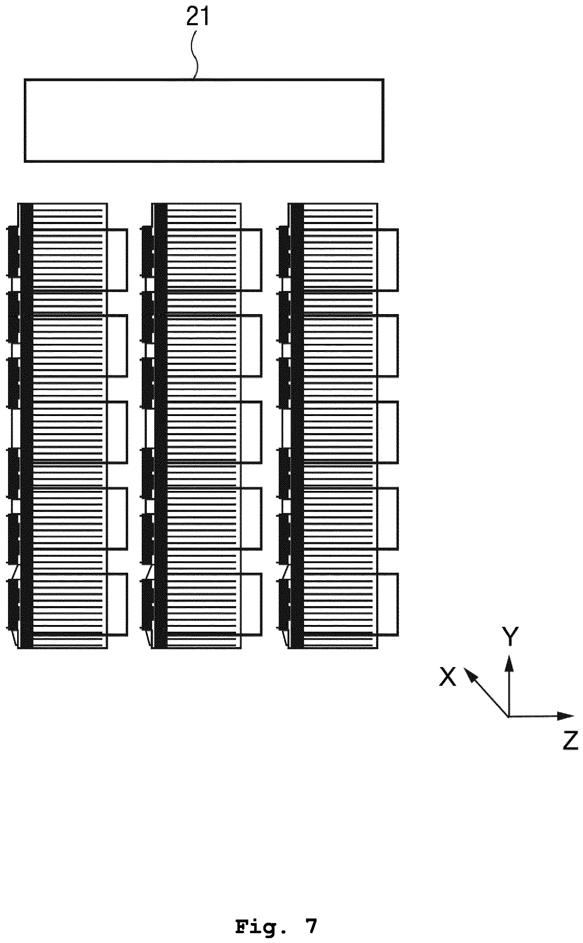

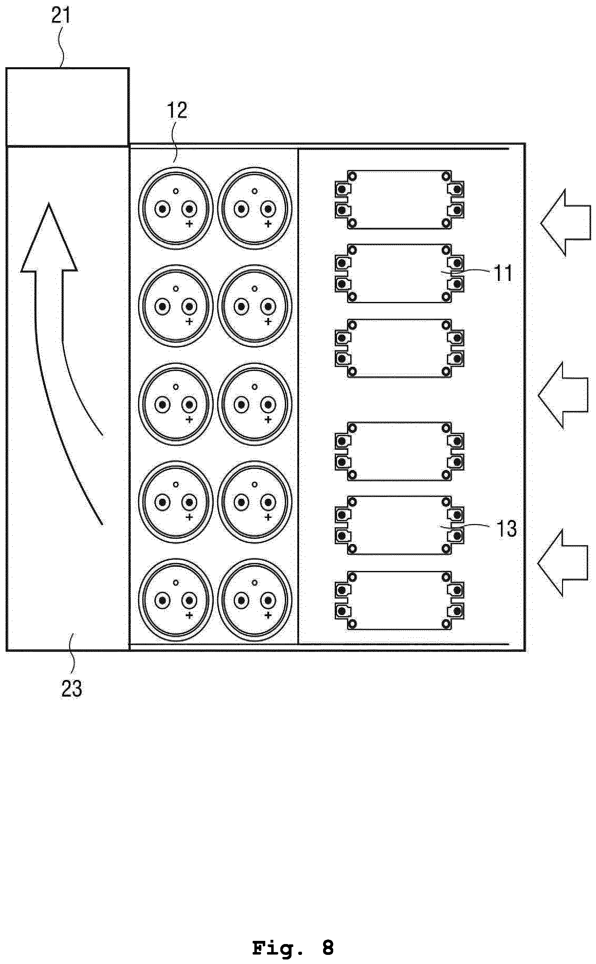

Fig. 7 is a demonstrative front view of an inverter cooling system having a fan assembly according to an embodiment of the present invention, with the direction of the view being the direction of approach of the cooling gas flow; in the coordinate system shown in fig. 7, the X-axis direction is a first direction, the Y-axis direction is a second direction, and the Z-axis is a third direction. Fig. 8 is a schematic air flow diagram of an inverter cooling system according to an embodiment of the present invention.

The inverter cooling system comprises: the inverter 20 as shown in fig. 5, specifically comprising: at least one inverter module set, each inverter module set comprising at least two inverter modules 10 arranged adjacently and in parallel in the first direction, wherein the inverter module 10 may be implemented as the inverter module shown in any of figs. 2 - 4; a bus 22, with each inverter module 10 being respectively connected to the bus 20 in the first direction; a common wind channel 23, which extends, in the second direction, past a wind outlet for cooling gas flow of each inverter module set; and a fan assembly 21, arranged on one side of the inverter 20 in the second direction, and connected to the common wind channel 23.

A preferred arrangement position of the fan assembly 21 has been described demonstratively above. Those skilled in the art will realize that such a description is purely demonstrative, and not intended to define the scope of protection of embodiments of the present invention.

In summary, the inverter module in embodiments of the present invention comprises a rectifier unit, a DC link unit and an inversion unit, wherein the rectifier unit and the inversion unit are located upstream in the flow direction of the cooling gas flow; and the DC link unit is disposed downstream in the flow direction of the cooling gas flow. Clearly, in an embodiment of the present invention, a modular and compact inverter module is proposed, which is very convenient to install and disassemble. Moreover, the rectifier unit and the inversion unit are in parallel relative to the cooling gas flow, hence the rectifier unit and the inversion unit have the same cooling effect; even if an IGBT or MOSFET, which generates a large amount of heat, is used in the rectifier unit, the rectifier unit can still be cooled well.

Furthermore, since the rectifier unit, the DC link unit and the inversion unit are arranged in the same plane, the connection of the DC bus is very convenient. In addition, one or more inverter modules proposed in an embodiment of the present invention can form an inverter, and the capacity of the inverter can be easily expanded by means of identical modules. Moreover, the present invention utilizes cabinet height more effectively, so the overall size of the system is compact.

## Claims

1. An inverter cooling system, the inverter cooling system comprising:
an inverter (20), the inverter (20) comprising:
at least one inverter module set, each inverter module set comprising at least two inverter modules (10) arranged adjacently and in parallel in a first direction;
a bus (22), wherein each inverter module (10) is respectively connected to the bus (22) in the first direction, wherein each inverter module (10) comprises:
a rectifier unit (11), a DC link unit (12), and an inversion unit (13), wherein:
the rectifier unit (11) comprises at least two rectifier elements (111);
the inversion unit (13) comprises at least two inversion elements (131); and
the DC link unit (12) comprises at least two DC link elements (121),
the inverter cooling system further comprising a common wind channel (23) for gathering gas flows which have performed a cooling action on the inverter modules (10) in the inverter (20), which extends past a wind outlet for a cooling gas flow of each inverter module set;
a fan assembly (21) is arranged on one side of the common wind channel (23) and being directly connected to the common wind channel (23) and configured to draw gathered gas flows out of the common wind channel (23), and the inverter cooling system is **characterized in that** the rectifier unit (11) and the inversion unit (13)are located upstream in a flow direction of a cooling gas flow, and the DC link unit (12) is disposed downstream in the flow direction of the cooling gas flow.

2. The inverter cooling system according to claim 1, **characterized in that**
the at least two rectifier elements (111) are arranged along a first line (1), the first line (1) being perpendicular to the flow direction of the cooling gas flow;
the at least two inversion elements (131) are arranged along a second line (2), the second line (2) being perpendicular to the flow direction of the cooling gas flow, and wherein the first line (1) is parallel to the second line (2).

3. The inverter cooling system according to claim 2, **characterized in that** the first line (1) coincides with the second line (2).

4. The inverter cooling system according to claim 2 or 3, **characterized in that** the at least two DC link elements (121) are arranged along, or in multiple rows respectively parallel to, a third line (3), wherein the third line (3) is parallel to the first line (1).

5. The inverter cooling system according to any of the preceding claims, **characterized in that** the rectifier unit (11), the DC link unit (12) and the inversion unit (13) are all arranged on a first mounting surface (24) of a mounting frame (30) of the inverter module (10).

6. The inverter cooling system according to claim 5, **characterized in that** a cooling fin (14) is provided on a second side (25), adjoining the first mounting surface (24), of the mounting frame (30), wherein the second side (25) is a side close to the rectifier unit (11) and the inversion unit (13).

7. The inverter cooling system according to claim 5, **characterized in that** an identical heat sink is allocated for the rectifier unit (11) and the inversion unit (13).

8. The inverter cooling system according to claim 5, **characterized in that** a different heat sink is allocated for the rectifier unit (11) and the inversion unit (13) respectively.

9. The inverter cooling system according to claim 7 or 8, **characterized in that** the heat sink is located on a second mounting surface, opposite to the first mounting surface (24), of the mounting frame (30).

10. The inverter cooling system according to any of the preceding claims, **characterized in that** the rectifier unit (11) comprises a three-phase rectifier element or a single-phase rectifier element, and the inversion unit (13) comprises a three-phase inversion element or a single-phase inversion element.

11. The inverter cooling system according to any of the preceding claims, **characterized in that** the rectifier unit (11) comprises a diode, a thyristor, an insulated-gate bipolar transistor or a metal oxide semiconductor field effect transistor.

12. The inverter cooling system according to any of the preceding claims, **characterized in that** the inversion unit (13) comprises an insulated-gate bipolar transistor or a metal oxide semiconductor field effect transistor.

13. The inverter cooling system according to any of the preceding claims, **characterized in that** the DC link unit (12) comprises a DC bus capacitor set.

## Patentansprüche

1. Wechselrichterkühlsystem, wobei das Wechselrichterkühlsystem umfasst:
einen Wechselrichter (20), wobei der Wechselrichter (20) umfasst:
mindestens einen Wechselrichtermodulsatz, wobei jeder Wechselrichtermodulsatz mindestens zwei in einer ersten Richtung nebeneinander und parallel angeordnete Wechselrichtermodule (10) umfasst;
einen Bus (22), wobei jedes Wechselrichtermodul (10) jeweils in der ersten Richtung mit dem Bus (22) verbunden ist, wobei jedes Wechselrichtermodul (10) umfasst:
eine Gleichrichtereinheit (11), eine Zwischenkreiseinheit (12) und eine Wechselrichtereinheit (13), wobei:
die Gleichrichtereinheit (11) mindestens zwei Gleichrichterelemente (111) umfasst;
die Wechselrichtereinheit (13) mindestens zwei Wechselrichterelemente (131) umfasst; und
die Zwischenkreiseinheit (12) mindestens zwei Zwischenkreiselemente (121) umfasst,
das Wechselrichterkühlsystem ferner einen gemeinsamen Windkanal (23) zum Sammeln von Gasströmen umfasst, die eine Kühlwirkung auf die Wechselrichtermodule (10) in dem Wechselrichter (20) ausgeübt haben, der sich an einem Windauslass für einen Kühlgasstrom jedes Wechselrichtermodulsatzes vorbei erstreckt;
eine Gebläseanordnung (21) auf einer Seite des gemeinsamen Windkanals (23) angeordnet und direkt mit dem gemeinsamen Windkanal (23) verbunden ist und dazu ausgelegt ist, gesammelte Gasströme aus dem gemeinsamen Windkanal (23) herauszuziehen, und das Wechselrichterkühlsystem **dadurch gekennzeichnet ist, dass** die Gleichrichtereinheit (11) und die Wechselrichtereinheit (13) stromaufwärts in einer Strömungsrichtung eines Kühlgasstroms angeordnet sind und die Zwischenkreiseinheit (12) stromabwärts in der Strömungsrichtung des Kühlgasstroms angeordnet ist.

2. Wechselrichterkühlsystem gemäß Anspruch 1, **dadurch gekennzeichnet, dass**
die mindestens zwei Gleichrichterelemente (111) entlang einer ersten Linie (1) angeordnet sind, wobei die erste Linie (1) rechtwinklig zur Strömungsrichtung des Kühlgasstroms verläuft;
die mindestens zwei Wechselrichterelemente (131) entlang einer zweiten Linie (2) angeordnet sind, wobei die zweite Linie (2) rechtwinklig zur Strömungsrichtung des Kühlgasstroms verläuft und wobei die erste Linie (1) parallel zur zweiten Linie (2) verläuft.

3. Wechselrichterkühlsystem gemäß Anspruch 2, **dadurch gekennzeichnet, dass** die erste Linie (1) mit der zweiten Linie (2) übereinstimmt.

4. Wechselrichterkühlsystem gemäß Anspruch 2 oder 3, **dadurch gekennzeichnet, dass** die mindestens zwei Zwischenkreiselemente (121) entlang oder in mehreren Reihen jeweils parallel zu einer dritten Linie (3) angeordnet sind, wobei die dritte Linie (3) parallel zur ersten Linie (1) verläuft.

5. Wechselrichterkühlsystem gemäß einem der vorhergehenden Ansprüche, **dadurch gekennzeichnet, dass** die Gleichrichtereinheit (11), die Zwischenkreiseinheit (12) und die Wechselrichtereinheit (13) alle auf einer ersten Montagefläche (24) eines Montagerahmens (30) des Wechselrichtermoduls (10) angeordnet sind.

6. Wechselrichterkühlsystem gemäß Anspruch 5, **dadurch gekennzeichnet, dass** eine Kühlrippe (14) auf einer zweiten, an die erste Montagefläche (24) angrenzenden Seite (25) des Montagerahmens (30) vorgesehen ist, wobei die zweite Seite (25) eine Seite nahe der Gleichrichtereinheit (11) und der Wechselrichtereinheit (13) ist.

7. Wechselrichterkühlsystem gemäß Anspruch 5, **dadurch gekennzeichnet, dass** für die Gleichrichtereinheit (11) und die Wechselrichtereinheit (13) ein identischer Kühlkörper vorgesehen ist.

8. Wechselrichterkühlsystem gemäß Anspruch 5, **dadurch gekennzeichnet, dass** für die Gleichrichtereinheit (11) und die Wechselrichtereinheit (13) jeweils ein anderer Kühlkörper vorgesehen ist.

9. Wechselrichterkühlsystem gemäß Anspruch 7 oder 8, **dadurch gekennzeichnet, dass** der Kühlkörper auf einer zweiten, der ersten Montagefläche (24) gegenüberliegenden Montagefläche des Montagerahmens (30) angeordnet ist.

10. Wechselrichterkühlsystem gemäß einem der vorhergehenden Ansprüche, **dadurch gekennzeichnet, dass** die Gleichrichtereinheit (11) ein dreiphasiges Gleichrichterelement oder ein einphasiges Gleichrichterelement umfasst und die Wechselrichtereinheit (13) ein dreiphasiges Wechselrichterelement oder ein einphasiges Wechselrichterelement umfasst.

11. Wechselrichterkühlsystem gemäß einem der vorhergehenden Ansprüche, **dadurch gekennzeichnet, dass** die Gleichrichtereinheit (11) eine Diode, einen Thyristor, einen Bipolartransistor mit isoliertem Gate oder einen Metalloxidhalbleiterfeldeffekttransistor umfasst.

12. Wechselrichterkühlsystem gemäß einem der vorhergehenden Ansprüche, **dadurch gekennzeichnet, dass** die Wechselrichtereinheit (13) einen Bipolartransistor mit isoliertem Gate oder einen Metalloxidhalbleiterfeldeffekttransistor umfasst.

13. Wechselrichterkühlsystem gemäß einem der vorhergehenden Ansprüche, **dadurch gekennzeichnet, dass** die Zwischenkreiseinheit (12) einen Gleichstrombuskondensatorsatz umfasst.

## Revendications

1. Système de refroidissement d'onduleur, le système de refroidissement d'onduleur comprenant :
un onduleur (20), l'onduleur (20) comprenant :
au moins un ensemble module onduleur, chaque ensemble module onduleur comprenant au moins deux modules onduleurs (10) agencés de manière adjacente et en parallèle dans une première direction ;
un bus (22), dans lequel chaque module onduleur (10) est relié respectivement au bus (22) dans la première direction, dans lequel chaque module onduleur (10) comprend :
une unité de redresseur (11), une unité de liaison CC (12), et une unité d'ondulation (13), dans lequel
l'unité de redresseur (11) comprend au moins deux éléments redresseurs (111) ;
l'unité d'ondulation (13) comprend au moins deux éléments d'ondulation (131) ; et
l'unité de liaison CC (12) comprend au moins deux éléments de liaison CC (121),
le système de refroidissement d'onduleur comprenant en outre un canal d'aération commun (23) pour rassembler des écoulements de gaz qui ont réalisé une action de refroidissement sur les modules onduleurs (10) dans l'onduleur (20), qui s'étend derrière une sortie d'aération pour un écoulement de gaz de refroidissement de chaque ensemble module onduleur ;
un ensemble ventilateur (21) étant agencé sur un côté du canal d'aération commun (23) et étant directement relié au canal d'aération commun (23) et configuré pour aspirer des écoulements de gaz rassemblés hors du canal d'aération commun (23), et le système de refroidissement d'onduleur étant **caractérisé en ce que** l'unité de redresseur (11) et l'unité d'ondulation (13) sont situées en amont dans une direction d'écoulement d'un écoulement de gaz de refroidissement, et l'unité de liaison CC (12) est disposée en aval dans la direction d'écoulement de l'écoulement de gaz de refroidissement.

2. Système de refroidissement d'onduleur selon la revendication 1, **caractérisé en ce que**
les au moins deux éléments redresseurs (111) sont agencés le long d'une première ligne (1), la première ligne (1) étant perpendiculaire à la direction d'écoulement de l'écoulement de gaz de refroidissement ;
les au moins deux éléments d'ondulation (131) sont agencés le long d'une seconde ligne (2), la seconde ligne (2) étant perpendiculaire à la direction d'écoulement de l'écoulement de gaz de refroidissement, et dans lequel la première ligne (1) est parallèle à la seconde ligne (2).

3. Système de refroidissement d'onduleur selon la revendication 2, **caractérisé en ce que** la première ligne (1) coïncide avec la seconde ligne (2).

4. Système de refroidissement d'onduleur selon la revendication 2 ou 3, **caractérisé en ce que** les au moins deux éléments de liaison CC (121) sont agencés le long de, ou dans plusieurs rangées respectivement parallèles à, une troisième ligne (3), dans lequel la troisième ligne (3) est parallèle à la première ligne (1).

5. Système de refroidissement d'onduleur selon l'une quelconque des revendications précédentes, **caractérisé en ce que** l'unité de redresseur (11), l'unité de liaison CC (12) et l'unité d'ondulation (13) sont toutes agencées sur une première surface de montage (24) d'un cadre de montage (30) du module onduleur (10).

6. Système de refroidissement d'onduleur selon la revendication 5, **caractérisé en ce qu'**une ailette de refroidissement (14) est fournie sur un second côté (25), de manière contiguë à la première surface de montage (24), du cadre de montage (30), dans lequel le second côté (25) est un côté proche de l'unité de redresseur (11) et de l'unité d'ondulation (13).

7. Système de refroidissement d'onduleur selon la revendication 5, **caractérisé en ce qu'**un dissipateur thermique identique est alloué pour l'unité de redresseur (11) et l'unité d'ondulation (13).

8. Système de refroidissement d'onduleur selon la revendication 5, **caractérisé en ce qu'**un dissipateur thermique différent est alloué respectivement pour l'unité de redresseur (11) et l'unité d'ondulation (13).

9. Système de refroidissement d'onduleur selon la revendication 7 ou 8, **caractérisé en ce que** le dissipateur thermique est situé sur une seconde surface de montage, opposée à la première surface de montage (24), du cadre de montage (30).

10. Système de refroidissement d'onduleur selon l'une quelconque des revendications précédentes, **caractérisé en ce que** l'unité de redresseur (11) comprend un élément redresseur triphasé ou un élément redresseur monophasé, et l'unité d'ondulation (13) comprend un élément d'ondulation triphasé ou un élément d'ondulation monophasé.

11. Système de refroidissement d'onduleur selon l'une quelconque des revendications précédentes, **caractérisé en ce que** l'unité de redresseur (11) comprend une diode, un thyristor, un transistor bipolaire à grille isolée ou un transistor à effet de champ à semiconducteur à oxyde métallique.

12. Système de refroidissement d'onduleur selon l'une quelconque des revendications précédentes, **caractérisé en ce que** l'unité d'ondulation (13) comprend un transistor bipolaire à grille isolée ou un transistor à effet de champ à semiconducteur à oxyde métallique.

13. Système de refroidissement d'onduleur selon l'une quelconque des revendications précédentes, **caractérisé en ce que** l'unité de liaison CC (12) comprend un ensemble condensateur de bus CC.
